Europäisches Patentamt

European Patent Office

Office européen des brevets

(19)

(11) Publication number : **0 511 801 A2**

## (12) EUROPEAN PATENT APPLICATION

(21) Application number : **92303759.2**

(22) Date of filing : **24.04.92**

(51) Int. Cl.$^5$ : **C04B 35/64, H01G 4/20, H01C 17/30**

(30) Priority : **30.04.91 JP 126880/91**

(43) Date of publication of application :
**04.11.92 Bulletin 92/45**

(84) Designated Contracting States :
**DE FR GB**

(71) Applicant : **NEC CORPORATION**
**7-1, Shiba 5-chome Minato-ku**
**Tokyo 108-01 (JP)**

(72) Inventor : **Omatsu, Kenichi**
**c/o NEC Corporation, 7-1 Shiba 5-chome,**
**Minato-ku**
**Tokyo 108-01 (JP)**

(74) Representative : **Abnett, Richard Charles et al**
**REDDIE & GROSE 16 Theobalds Road**
**London WC1X 8PL (GB)**

(54) Method for manufacturing multilayer ceramic electronic parts.

(57) For manufacturing multilayer ceramic electronic parts, first 20 to 50% by volume of binder is added to a ceramic powder, which in turn is dispersed in a solvent to prepare a slip after which a green sheet is formed from the slip by the tape casting method. Next, the sheet is cut to pieces of a fixed size for stacking in multilayers in a metal mold. Then said metal mold is pressed under a low pressure of not more than 100 kg/cm$^2$ to laminate the sheets into a green multilayer. Subsequently said green multilayer is heated to thermally decompose the binder included therein, and after the cold isostatic pressing is applied to the green multilayer, it is sintered to obtain a sintered matter. Further the sintered matter is processed in the following process to obtain the object mutilayer ceramic electronic parts. Since the pressure which is applied in pressing of the sheets for laminating them is low, the porosity of the green multilayer becomes high enough that the following thermal decomposition of the binder is easily performed. Further, by applying cold isostatic pressing subsequently to the green multilayer, the post-sintering density of the sintered matter.becomes high enough to provide adequate characteristics of the matter.

FIG.2

EP 0 511 801 A2

## BACKGROUND OF THE INVENTION

Field of the Invention:

The present invention relates to a method of manufacturing ceramic electronic parts with a multilayer structure.

Description of the Prior Art:

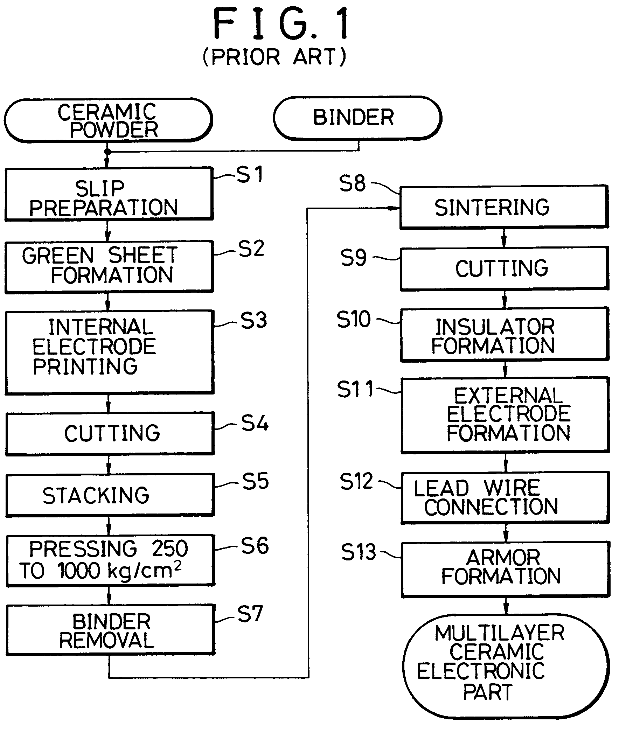

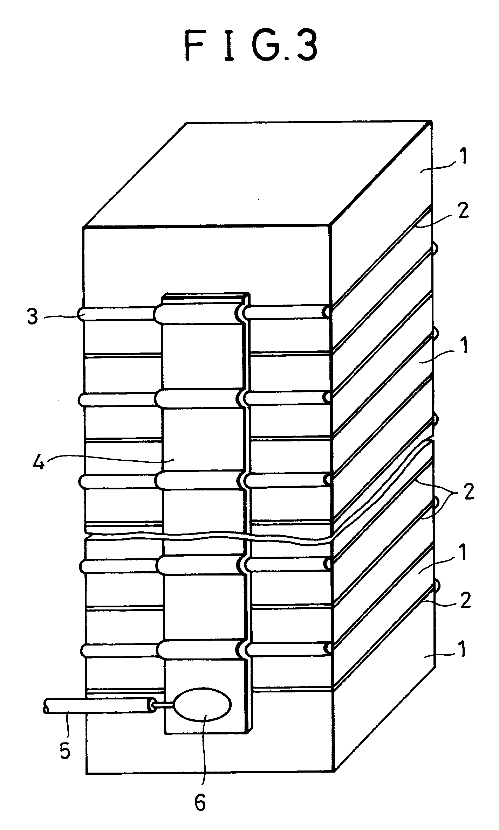

A chip type capacitor is shown in Fig.3 as an example of a multilayer ceramic electronic part. An example of a conventional method for manufacturing this chip type capacitor is shown in the process chart in Fig.1. In the process, an organic binder is first added to a ceramic powder such as $Pb(Ti,Zr)O_3$, which is then dispersed in an organic solvent to prepare a slip $(S_1)$, and a green sheet is formed by the tape casting method $(S_2)$. After an electrode paste is applied on this green sheet by the screen printing method $(S_3)$, the green sheet is cut to a predetermined dimension $(S_4)$. Next, a predetermined number of pieces of this cut sheet is stacked in multilayers in a metal mold one by one $(S_5)$ and pressed with a punch placed thereon to be laminated at temperatures as high as the binder flows and at pressures from 250 to 1000 $kg/cm^2$ $(S_6)$. A green multilayered matter thus obtained is heated up to a temperature at which the binder is decomposed and after the binder in the green multilayer matter is removed $(S_7)$, the green multilayer is sintered to obtain a sintered matter $(S_8)$.

Through these steps, the green sheet is transformed to ceramic 1 shown in Fig.3, and the electrode paste to internal electrode 2. After the sintered matter thus obtained is cut to a fixed form $(S_9)$, internal electrode 2 is alternately divided into two groups and glass insulator 3 is formed on the exposed end of electrode 2 of one group on one side of the multilayered matter. Glass insulator 3 is also formed on the exposed end of electrode 2 of the other group on the opposed side of the matter $(S_{10})$. Then, a paste consisting mainly of silver is applied on each side of the matter by means of the screen printing method, and after being dried, the matter is sintered for ten minutes at a temperature of 600 °C to form external electrode 4 $(S_{11})$. Thereafter, lead wire 5 is bonded to external electrode 4 by using solder 6 $(S_{12})$, and further, not illustrated, resin is applied all over four sides and then hardened to form an armor thereof $(S_{13})$. In this way the object chip condensers are manufactured.

In the above conventional manufacturing method for the multilayer ceramic electronic parts, since the density of the green multilayer which has been pressed $(S_6)$ amounts to as high as 60 % of the theoretical density thereof, the problem occurs that the time required for decomposing the binder is prolonged excessively because degasing of the gas generated at the time of decomposition of the binder becomes harder the bigger the volume. In order to solve this problem, applying a method in which the green multilayer was divided into small pieces to increase the surface area per volume in order to have the decomposition gas escape easily from the green multilayer was studied; however, when this method is applied, another problem occurs in that not only the number of processes is increased, but also the yield of the material is decreased. Further, applying a method in which a low pressure was used for pressing to decrease the green density for easy degasing of the decomposed gas was studied, but there was another problem that, when a low density green multilayer was sintered, the post-sintering density of the matter remained so low that no adequate characteristics of said matter could be obtained.

## SUMMARY OF THE INVENTION

An object of the present invention is to provide a method for manufacturing multilayer ceramic electronic parts which makes it possible that, after pressing treatment of the green multilayer is finished, the binder which remains inside the green multilayer can be rapidly removed, and that a good yield in production can be obtained.

Therefore, the present invention is characterized in that it comprises the step of hot pressing of the green sheet of multilayered fixed form under a pressure of not more than 100 $kg/cm^2$, which is lower than that of the conventional manufacturing method, and the step of obtaining a high post-forming density by pressing a green multilayer whose binder has been thermally decomposed, by means of a cold isostatic pressing method, prior to the process of obtaining a sintered matter by sintering the green multilayer after finishing thermal decomposition of the binder in said matter.

In one embodiment of the present invention, multilayer ceramic electronic parts are represented by a multilayer piezoelectric actuator or a chip type capacitor or a varistor, which embodiment comprises the step of applying paste onto each of the predesignated pieces of the green sheet for forming the internal electrode before stacking the pieces of the green sheet in multilayers in the metal mold.

Further, in another embodiment of the present invention, the cold isostatic pressing method is applied in such a way that the green multilayer whose binder has been removed is disposed in an autoclave after the matter is vacuum-packed, after which it is pressed by a high pressure liquid of 1000 through 4000 $kg/cm^2$.

The above and other objects, features and advantages of the present invention will become apparent from the following description when taken in conjunction with the accompanying drawings which illustrate a preferred embodiment of the present invention by way of example.

## BRIEF DESCRIPTION OF THE DRAWINGS

Fig.1 is a process flow chart of a conventional manufacturing method for multilayer ceramic electronic parts.

Fig.2 is a process flow chart of one embodiment of the manufacturing method for multilayer ceramic electronic parts of the present invention.

Fig.3 is a perspective view of a chip type capacitor as an example of multilayer ceramic electronic parts which is an object of the present invention.

## DETAILED DESCRIPTION OF THE PREFERRED EMBODIMENT

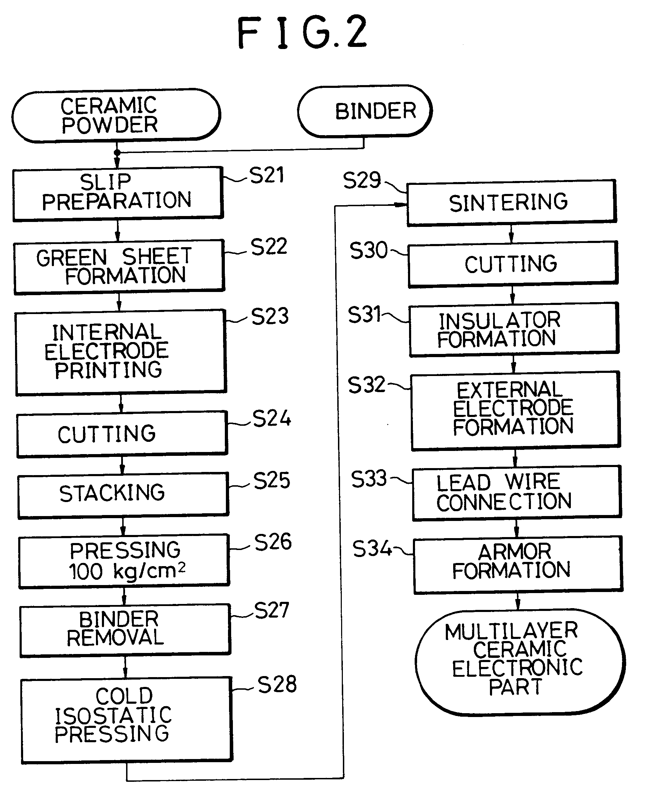

Next, one embodiment of the present invention will be described with reference to Fig.2.

In the process flow chart in Fig.2, approximately 30 % of an organic binder is first added to a ceramic powder composed mainly of $Pb(Ti,Zr)O_3$, then the above mixture is dispersed in an organic solvent to produce a slip ($S_{21}$) and a green sheet is formed with a film approximately 130 $\mu$m thick by the tape casting method ($S_{22}$). Next, a paste for an internal electrode is produced by kneading powder consisting of silver·palladium powder mixed in a ratio of 7:3 with a vehicle to a state of paste. The paste for the internal electrode is applied on the above green sheet to form an approximately 10 $\mu$m thick film by the screen printing method ($S_{23}$). The sheet is cut to a size of 70 mm X 100 mm ($S_{24}$), and then 30 sheets without the printed electrode paste, 120 sheets with the printed electrode paste, and further 30 sheets without the printed electrode paste are stacked in order in multilayer ($S_{25}$). The multilayered matter is heated to approximately 100 °C and pressed at 100 kg/cm² to be laminated ($S_{26}$). The green multilayer thus manufactured is heated to approximately 400 °C for approximately 50 hours to remove the binder in the green multilayer ($S_{27}$). Then, the green multilayer is vacuum-packed in a vinyl bag and placed in an autoclave filled with a liquid, and processed by the cold isostatic pressing with pressures of 1000 through 4000 kg/cm² by rising the pressure of the liquid in the autoclave ($S_{28}$). Next, the green multilayer is sintered at a temperature of approximately 1100 °C for two hours ($S_{29}$). By virtue of this sintering, the green multilayer becomes ceramic chip type capacitor 1 as shown in Fig.3 and the internal electrode paste internal electrode 2. Then after the sintered matter is cut to a fixed dimension ($S_{30}$), glass insulator 3 is formed on the exposed end of internal electrode 2 in the same way as the example of the conventional type described above ($S_{31}$). Further, the paste consisting mainly of silver is formed on each side by screen printing, and after being dried, the matter is sintered for 10 minutes at a temperature of 600 °C to form external electrode 4 ($S_{32}$). Thereafter, lead wire 5 is connected to external electrode 4 on each side of the matter by means of solder 6 ($S_{33}$) and though not illustrated, resin is coated all over four sides and then hardened to form an armor thereof ($S_{34}$). In this way, the object chip capacitor is manufactured.

As described above, in the present embodiment the sheet is pressed and laminated under a low pressure within the range in which lamination can be actualized, so that the green multilayer is manufactured with a high porosity. Therefore, even when the green multilayer is manufactured in a large volume to improve the yield of the material, it is possible to secure a sufficient amount of vent holes through which the gas generated by decomposition of the binder can pass through outside the matter, whereby it becomes possible to remove the binder in a short time. Further, a high post-forming density of the green multilayer can be obtained by applying the cold isostatic pressing to the matter after removal of the binder; incidentally, the post-sintering density can also reach the density which provides adequate characteristics of the matter.

In this connection and by using a manufacturing method embodying the present invention, the time required for the binder removal process was reduced to approximately 50 hours, one-fifth of the conventional removal time of approximately 250 hours. Also the yield of the matter was improved by approximately 20 % when compared with the case wherein the green multilayer was reduced to half in size for removing the binder. Further, when only the pressure is lowered in the pressing operation and the cold isostatic pressing is not applied thereto, the post-sintering density of the green multilayer reaches as high as 80 to 90 % of the theoretical density, however, it can reach more than 95 % by performing the cold isostatic pressing of the green multilayer, whereby it becomes possible to obtain strength and piezoelectric characteristics of the same level as those of the matter produced by the conventional manufacturing method.

Although a specific preferred embodiment of the present invention has been shown and described in detail, it should be understood that various changes and modifications may be made therein without departing from the scope of the appended claims.

## Claims

1. A method of manufacturing multilayer ceramic electronic parts, comprising the steps of:

preparing a slip by dispersing a mixture in a solvent wherein said mixture is made by adding a binder to a ceramic powder, and forming a green sheet from said slip by means of the tape casting method;

stacking said green sheet cut into pieces of a fixed form in a metal mold, and forming a green multilayer by pressing said stacked pieces of green sheet under a predesignated pressure;

thermally decomposing said binder which is contained in said green multilayer by the heating thereof;

obtaining a sintered matter by sintering said green multilayer after thermal decomposition of said binder; and

processing said sintered matter to obtain said multilayer ceramic electronic parts; characterized in that the pressure applied in the pressing operation in said process for laminating said pieces of said green sheet into the green multilayer is not more than 100 kg/cm²; and that the step of applying pressure by the cold isostatic pressing method to said green multilayer whose binder has been thermally decomposed is added between said step for thermal decomposition of the binder and said step for obtaining the sintered matter by sintering the green multilayer.

2. A method of manufacturing multilayer ceramic electronic parts according to claim 1, wherein,

said multilayer electronic parts are represented by a multilayer piezoelectric actuator or a chip type capacitor or a varistor; and

paste is applied onto each of the predesignated pieces of said green sheet for forming an internal electrode before stacking said pieces of said green sheet in multilayers in said metal mold.

3. A method of manufacturing multilayer ceramic electronic parts according to claim 1 or 2, wherein,

said cold isostatic pressing method functions in such a way that said green multilayer whose binder has been removed is disposed in an autoclave after said green multilayer is vacuum-packed and then pressure is applied to said matter by filing a high pressure liquid of 1000 through 4000 kg/cm² in said autoclave.

4. Multilayer ceramic electronic components manufactured by the method of any of claims 1, 2 or 3.

# F I G. 1
## (PRIOR ART)

```
┌─────────────┐        ┌─────────────┐
│  CERAMIC    │        │   BINDER    │
│   POWDER    │        │             │
└─────────────┘        └─────────────┘

┌─────────────┐ S1              S8 ┌─────────────┐
│    SLIP     │                    │  SINTERING  │
│ PREPARATION │                    └─────────────┘
└─────────────┘

┌─────────────┐ S2              S9 ┌─────────────┐
│ GREEN SHEET │                    │   CUTTING   │
│  FORMATION  │                    └─────────────┘
└─────────────┘

┌─────────────┐ S3          S10 ┌─────────────┐
│  INTERNAL   │                 │  INSULATOR  │
│  ELECTRODE  │                 │  FORMATION  │
│  PRINTING   │                 └─────────────┘
└─────────────┘

┌─────────────┐ S4          S11 ┌─────────────┐
│   CUTTING   │                 │  EXTERNAL   │
└─────────────┘                 │  ELECTRODE  │
                                │  FORMATION  │
┌─────────────┐ S5             └─────────────┘
│   STACKING  │
└─────────────┘              S12 ┌─────────────┐
                                 │  LEAD WIRE  │
┌───────────────┐ S6             │ CONNECTION  │
│ PRESSING 250  │                └─────────────┘
│ TO 1000 kg/cm²│
└───────────────┘            S13 ┌─────────────┐
                                 │    ARMOR    │
┌─────────────┐ S7               │  FORMATION  │
│   BINDER    │                  └─────────────┘
│   REMOVAL   │
└─────────────┘                  ┌─────────────┐
                                 │  MULTILAYER │
                                 │   CERAMIC   │
                                 │  ELECTRONIC │
                                 │    PART     │
                                 └─────────────┘
```

PRESSING 250 TO 1000 kg/cm$^2$

# F I G.2

```
┌──────────────┐        ┌──────────┐
│   CERAMIC    │        │  BINDER  │
│   POWDER     │        └──────────┘
└──────────────┘
```

| Left column | Right column |
|---|---|
| SLIP PREPARATION — S21 | S29 — SINTERING |
| GREEN SHEET FORMATION — S22 | S30 — CUTTING |
| INTERNAL ELECTRODE PRINTING — S23 | S31 — INSULATOR FORMATION |
| CUTTING — S24 | S32 — EXTERNAL ELECTRODE FORMATION |
| STACKING — S25 | S33 — LEAD WIRE CONNECTION |
| PRESSING 100 kg/cm$^2$ — S26 | S34 — ARMOR FORMATION |
| BINDER REMOVAL — S27 | MULTILAYER CERAMIC ELECTRONIC PART |
| COLD ISOSTATIC PRESSING — S28 | |

# F I G.3